Europäisches Patentamt

European Patent Office

Office européen des brevets

(19)

(11) Numéro de publication : **0 169 122**
**B1**

(12) **FASCICULE DE BREVET EUROPÉEN**

(45) Date de publication du fascicule du brevet :
01.02.89

(51) Int. Cl.⁴ : **H 01 L 29/93**

(21) Numéro de dépôt : **85401264.8**

(22) Date de dépôt : **25.06.85**

(54) Elément à capacité variable, commandable par une tension continue.

(30) Priorité : 03.07.84 FR 8410521

(43) Date de publication de la demande :
22.01.86 Bulletin 86/04

(45) Mention de la délivrance du brevet :
01.02.89 Bulletin 89/05

(84) Etats contractants désignés :
DE GB NL

(56) Documents cités :
DE--A-- 2 829 212
FR--A-- 2 021 035
ELECTRONICS LETTERS, vol. 16, no. 9, 24 avril 1980,
pages 317-319, Hitchin, Herts., GB; J.J. HARRIS et al.:
"Low noise GaAs varactor and mixer diodes prepared by molecular beam epitaxy"
R.E. Williams: "Gallium Arsenide Processing Techniques", Artech House, Inc., Dedham, MA, 1984 p. 17-
21 and 306-309

(73) Titulaire : THOMSON-CSF
173, Boulevard Haussmann
F-75379 Paris Cedex 08 (FR)

(72) Inventeur : Magarshack, John
THOMSON-CSF SCPI 173, bld Haussmann
F-75379 Paris Cedex 08 (FR)
Inventeur : Kohn, Erhard
THOMSON-CSF SCPI 173, bld Haussmann
F-75379 Paris Cedex 08 (FR)
Inventeur : Perea, Ernesto
THOMSON-CSF SCPI 173, bld Haussmann
F-75379 Paris Cedex 08 (FR)
Inventeur : Pavlidis, Dimitrios
THOMSON-CSF SCPI 173, bld Haussmann
F-75379 Paris Cedex 08 (FR)

(74) Mandataire : Taboureau, James et al
THOMSON-CSF SCPI 19, avenue de Messine
F-75008 Paris (FR)

## Description

La présente invention concerne un élément à capacité variable, commandable par une tension, plus particulièrement destiné à l'intégration sur une pastille de circuit intégré. Cet élément à capacité commandable permet de supprimer les selfs de choc qui filtrent la tension de commande par rapport à la tension du signal, ainsi que les capacités d'isolement qui, normalement, séparent une capacité commandable selon l'art connu et le reste du circuit : néanmoins, dans l'élément selon l'invention, la tension de commande n'interfère pas avec le signal. L'élément à capacité commandable selon l'invention concerne surtout le domaine des hyperfréquences.

Jusqu'à présent, le dispositif à capacité variable — qui ne soit pas constitué par une capacité dont la valeur est modifiée mécaniquement — le plus connu et le plus utilisé est une diode Schottky polarisée en inverse, connue sous le nom de « Varactor ». La capacité présentée par la métallisation sur le matériau semiconducteur dans une diode Schottky varie avec la tension de commande appliquée sur la cathode de la diode. Cette capacité variable peut être utilisée comme élément d'accord pour un oscillateur ou un filtre par exemple, mais l'inconvénient de ce type de capacité variable est que la tension continue de commande doit être isolée du signal hyperfréquence par un filtre, comportant au moins une self de choc, et souvent deux selfs. La présence d'une self de choc à la surface d'une pastille de circuit intégré est à proscrire chaque fois que cela est possible, car une self ou un filtre occupe une place trop importante sur la pastille et diminue considérablement la densité d'intégration.

Un circuit intégré comprenant au moins une diode à capacité variable est connu du brevet allemand DE-A-2829212. Mais ce circuit intégré est en silicium, et la ou les deux diodes à capacité variable sont à jonction p-n, ce qui n'est pas souhaitable avec les matériaux rapides tels que Ga As ou ceux de la famille III-V, dont les circuits intégrés sont réalisés en matériau homotype, dopé N, avec hétérojonctions si nécessaire. Selon le document antérieur, la tension de commande n'est pas canalisée à travers une résistance bien définie en forme d'appendice d'une zone active implantée, mais peut s'exercer sur toute la surface d'une couche épitaxiale de faible résistivité. En outre, le circuit intégré du brevet DE-A-2829212 est orienté sur une structure destinée à isoler l'élément à capacité variable du reste du circuit, parce que le substrat en silicium est conducteur, et non pas semi-isolant.

L'élément à capacité variable selon l'invention s'inspire d'un élément à résistance variable, commandable par une tension, bien connu : le transistor à effet de champ. Dans un transistor à effet de champ non polarisé, la tension continue appliquée sur la grille fait varier les résistances entre source et canal et entre canal et drain en pinçant plus ou moins le canal par la zone de déplétion par exemple, si c'est un transistor à effet de champ à déplétion : ainsi la tension de commande sur la grille d'un transistor à effet de champ n'est pas connectée directement sur la tension de signal, et un filtre ou une self de choc sur la tension de grille n'est pas nécessaire. La tension de commande agit par effet capacitif sur le canal.

Le schéma équivalent d'un élément à capacité variable selon l'invention permute et les résistances et les capacités des schémas équivalents d'un transistor à effet de champ : c'est donc un schéma à structure en T. Les deux bornes d'accès à cet élément sont constituées par des capacités qui sont des diodes Schottky, les diodes étant montées en cathode commune. La borne de commande est constituée par une résistance à travers laquelle est appliquée la tension de commande : la résistance est connectée au point commun entre les deux diodes. La réalisation de l'élément à capacité variable selon l'invention s'attache à ce que les capacités présentées par les deux diodes soient des capacités pures, sans résistance d'accès parasite. Dans une forme préférée de réalisation de l'invention, les diodes sont constituées par une zone dite active, dopée, dans un substrat semi-isolant : deux métallisations Schottky sont déposées côte à côte sur cette zone active constituant ainsi des jonctions Schottky. Ces deux métallisations sont en contact électrique avec deux lignes microbandes qui constituent les bornes d'accès à l'élément. La zone dopée comporte en outre un appendice en forme de bande, sur lequel est pris un contact ohmique : les dimensions et le taux de dopage de cet appendice règlent la valeur de sa résistance. La tension de commande est appliquée sur le contact ohmique.

Dans d'autres formes de réalisation, adaptées selon les nécessités, l'élément à capacité variable ne comporte qu'une seule diode ou au contraire en comporte plus de deux, ce qui en fait un élément qui, à partir d'une seule tension de commande, permet de contrôler ou d'accorder une pluralité de circuits.

De façon plus précise l'invention concerne un élément à capacité variable, commandable par une tension continue ($V_{comm}$) n'interférant pas avec une tension hyperfréquence ($V_{HF}$) modulée par ledit élément, dont la capacité variable est formée par la jonction d'au moins une diode (12) polarisée en inverse par la tension de commande ($V_{comm}$) à travers une résistance (11), cet élément, dont les bornes d'accès sont constituées par des lignes microbandes (20, 21), comportant :

— une zone active (14), dopée au niveau $10^{17}$ at.cm$^{-3}$, implantée dans un substrat semiconducteur en matériau semi-isolant ($n_D \leqslant 10^{14}$ at.cm$^{-3}$) et

— deux métallisations séparées (17, 18), chacune recouvrant partiellement la zone active (14) et partiellement une microbande d'accès (20, 21), l'une au moins (17) desdites métallisations formant avec la zone active (14) une diode Schottky, ladite résistance (11) étant formée par un appendice (15) de la zone active (14), également implanté dans le substrat semiconducteur latéral à la zone active (14), en contact ohmique avec ladite zone active (14), et partiellement recouvert par une métallisation ohmique (16) sur laquelle est appliquée la tension de commande ($V_{comm}$), les dimensions et le taux de dopage de cet appendice (15) permettant de déterminer la valeur de la résistance (11).

L'invention sera mieux comprise par la description qui est faite de quelques exemples de réalisation, cette description s'appuyant sur les figures jointes en annexe qui représentent :

— figure 1 : schéma de filtrage de la tension de commande d'une diode schottky utilisée en capacité variable, selon l'art connu,

— figure 2 : schéma équivalent de l'élément à capacité variable commandé par une tension, selon l'invention,

— figure 3 : schéma électrique de l'élément à capacité variable selon l'invention,

— figure 4 : exemple de réalisation de l'élément à capacité variable selon l'invention, conformément aux figures 2 et 3,

— figure 5 : schéma équivalent de l'élément à capacité variable, dans une première variante de l'invention,

- figure 6 : schéma électrique de l'élément à capacité variable de la figure 5,

- figure 7 : exemple de réalisation de l'élément à capacité variable selon l'invention conformément à la première variante des figures 5 et 6,

- figure 8 : vue en coupe d'un cristal semiconducteur, montrant la formation des capacités dans l'élément à capacité variable de l'invention,

- figure 9 : disposition des métallisations pour augmenter la valeur des capacités dans une seconde variante de l'élément selon l'invention,

- figure 10 : schéma électrique d'un transformateur accordé par une capacité variable selon l'invention,

- figure 11 : schéma de réalisation du transformateur de la figure 10,

- figure 12 : schéma équivalent d'un élément à capacité variable comportant une pluralité de capacités variables selon une troisième variante de l'invention,

- figure 13 : exemple de réalisation de l'élément à capacité variable selon l'invention conformément à la figure 12.

L'invention est essentiellement destinée à l'intégration d'un circuit hyperfréquence sur des matériaux tels que Ga As ou les composés de la famille III-V.

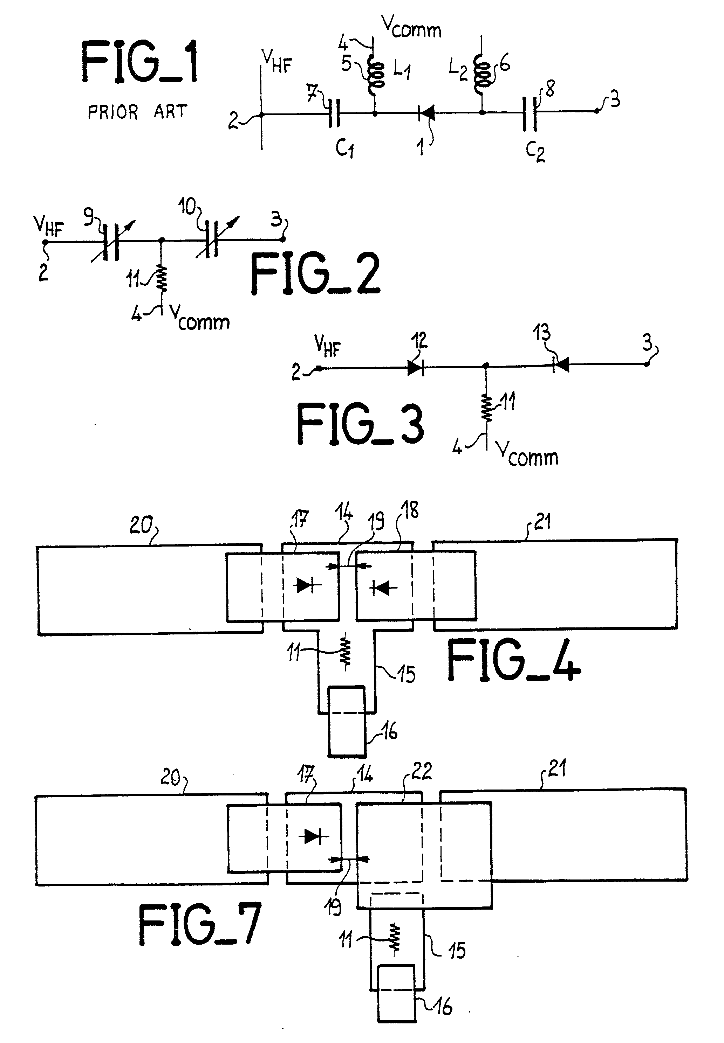

La figure 1 représente le schéma de filtrage de la tension de commande d'une diode Schottky utilisée en capacité variable, selon l'art connu.

S'il est nécessaire de faire varier la capacité entre deux bornes 2 et 3 d'un circuit, il est connu de monter une diode Schottky 1 qui est polarisée en inverse. Ce type de diode est plus généralement connu sous le nom de Varicap ou Varactor.

Une tension de commande $V_{comm}$ est appliquée par une liaison 4 sur la cathode de la diode 1. Mais si la liaison 4 était appliquée sans aucune précaution à la cathode de la diode 1, il y aurait interférence entre la tension continue de commande $V_{comm}$ et la tension de signal $V_{HF}$ qui est véhiculée au point 2 du circuit. Par conséquent pour découpler la tension continue de commande $V_{comm}$ et la tension de signal $V_{HF}$, il est obligatoire de filtrer la tension continue par au moins une self de choc L1, repérée 5, connectée à la cathode de la diode 1. Plus fréquemment, et à moins que le point repéré 3 du circuit ne soit à la masse, il est nécessaire de monter une seconde self de choc L2 repérée 6 sur l'anode de la diode, ainsi que deux condensateurs C1 et C2 repérés 7 et 8. Ce schéma de montage qui est très courant présente deux graves inconvénients lorsqu'on veut l'appliquer à un circuit intégré. Premièrement les selfs de choc occupent une grande surface sur la pastille du cristal dans lequel est réalisé le circuit intégré, ce qui s'oppose à la densification de l'intégration, et deuxièmement les condensateurs C1 et C2 ne sont pas souhaités en circuit intégré puisque eux aussi occupent une grande surface et sont délicats à réaliser, par une suite d'opération comportant des métallisations et des couches d'isolement.

L'objet de l'invention est donc de réaliser un élément à capacité variable, commandable par une tension continue, c'est-à-dire l'équivalent d'une diode Varicap, mais telle que les selfs de choc L1 et L2 et les capacités d'isolement C1 et C2 ne soient pas utiles, en vue de l'intégration sur un circuit intégré Ga As par exemple.

La figure 2 représente le schéma équivalent de l'élément à capacité variable, commandable par une tension, qui fait l'objet de l'invention. Ce schéma équivalent a une structure en forme de T, dans laquelle deux capacités variables repérées 9 et 10 sont interposées entre les points 2 et 3 d'un circuit hyperfréquence, ces points ayant reçu les mêmes indices de repères que sur la figure 1 de façon à faciliter le rapprochement et la comparaison. Les capacités variables 9 et 10 sont commandées par une tension continue de commande $V_{comm}$, appliquée à une liaison métallique 4, qui est réunie au point commun entre les deux capacités variables 9 et 10 par l'intermédiaire d'une résistance 11. La présence d'une capacité 9 entre le signal $V_{HF}$ et la tension de commande $V_{comm}$ fait qu'une self de filtrage n'est plus nécessaire. Ce schéma dont la structure est en forme de T, se rapproche du schéma équivalent d'un transistor à effet de champ dans lequel les deux capacités variables 9 et 10 seraient remplacées par deux résistances variables, et dans lequel la résistance 11 serait remplacée par une capacité fixe.

La figure 3 représente le schéma électrique correspondant au schéma équivalent à la figure 2 : la réalisation des capacités variables dans l'élément selon l'invention se fait au moyen de deux diodes 12 et 13, qui sont connectées en cathode commune. Au point commun aux deux cathodes est appliquée une tension de commande $V_{comm}$, ce qui fait que les diodes sont polarisées en inverse. Lorsqu'une tension continue est appliquée à travers la résistance 11 sur les cathodes des deux diodes 12 et 13, les capacités de celles-ci varient, et la capacité entre les points 2 et 3 du circuit varie également : la présence des diodes qui s'oppose au passage du courant, depuis la tension continue de commande en 4, vers le signal haute fréquence en 2, fait qu'il n'est pas utile de découpler la tension de commande.

La figure 4 représente un premier exemple de réalisation d'un élément à capacité variable selon l'invention, cette figure reprenant les schémas des figures 2 et 3.

Dans un substrat en matériau isolant ou semi-isolant, qui n'est pas représenté sur la figure de façon à la rendre plus claire, mais qui constitue le substrat de la pastille de circuit intégré, est réalisé un caisson 14 en matériau dopé. Ce caisson 14 constitue ce que l'on peut appeler une zone active par opposition au reste du substrat isolant ou semi-isolant. Il est dopé par implantation ionique, de type n avec un taux de dopage de l'ordre de $10^{17}$ at.cm$^{-3}$, le substrat semi-isolant étant, quant à lui, légèrement dopé ou involontairement dopé à un taux inférieur à $10^{14}$, ce qui revient à dire qu'il est semi-isolant. La zone active ou caisson 14 comporte un appendice 15, de forme préférentiellement rectangulaire, dont les dimensions, en conjonction avec le taux de dopage, permettent de déterminer la valeur de la résistance 11 par laquelle est appliquée la tension de commande $V_{comm}$. Cette tension de commande provient elle-même d'une métallisation 16, en contact ohmique avec l'appendice 15.

Le caisson 14 et son appendice 15 peuvent également être dopés de type p : la mobilité des trous étant plus faible que la mobilité des électrons, un dopage de type p amène une plus grande résistivité de l'appendice 15, ce qui a pour avantage de réaliser la résistance 11 sur une surface plus petite, grâce à un appendice 15 plus petit, et ainsi d'augmenter l'intégration.

Sur la zone active 14 sont déposées deux métallisations Schottky 17 et 18, qui comportent au moins deux bords parallèles séparés entre eux par une fente 19, large d'environ 5 μm. La jonction entre les métallisations Schottky 17 et 18 et la zone active 14 constitue les deux diodes Schottky.

Par ailleurs, les métallisations Schottky 17 et 18 sont en contact électrique, par recouvrement partiel, avec deux lignes microbandes, 20 et 21, qui présentent normalement une impédance de 50 ohms, avec une largeur typique de 73 μm et une épaisseur de substrat 100 μm. Les lignes microbandes 20 et 21 constituent les liaisons d'accès à l'élément à capacité variable selon l'invention : elles correspondent aux points 2 et 3 du schéma électrique de la figure 3.

Les lignes microbandes sont maintenues à une tension continue nulle. Le contact ohmique 16 est quant à lui polarisé positivement, et les deux diodes Schottky sont donc polarisées à l'inverse, ce qui réalise ainsi le schéma électrique de la figure 3.

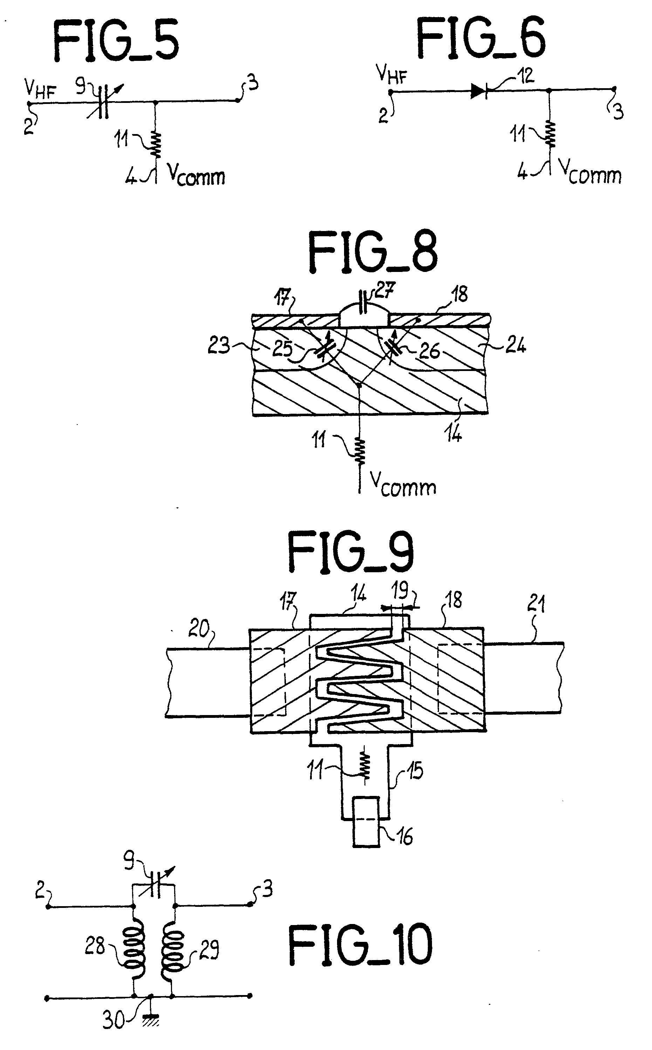

La figure 5 représente le schéma équivalent de l'élément à capacité variable, dans une première variante de l'invention, lorsque l'un des deux pôles du schéma, le pôle 3 par exemple, ne transmet pas un signal. Dans ce cas il n'est pas indispensable de réaliser un élément à capacité variable avec deux capacités variables telles que 9 et 10 représentées en figure 2. Une seule capacité variable 9, située entre la tension de signal $V_{HF}$ et la tension de commande $V_{comm}$ est utile et la capacité variable 10, située entre masse et la tension de commande peut être supprimée.

La figure 6 représente le schéma électrique de la figure 5, et la capacité variable 9 est donc, selon l'invention, réalisée sous la forme d'une seule diode 12, dont la capacité est commandée, à travers la résistance 11, par une tension de commande $V_{comm}$.

La figure 7 représente un exemple de réalisation de l'élément à capacité variable, conformément à la première variante des figures 5 et 6. Dans un substrat semi-isolant ou isolant, qui n'est pas représenté sur la figure 7, est réalisé un caisson 14 par implantation ionique, dopé de type n ou de type p comme il a été dit au sujet de la figure 4. A côté de ce premier caisson 14 est réalisé un second caisson 15, qui correspond à l'implantation de la résistance 11 à travers laquelle est appliquée la tension de commande de la diode. Le caisson 15 peut être en contact direct avec le caisson 14, comme cela a été représenté à la figure 4, ou il peut être séparé de celui-ci tel que représenté en figure 7.

Sur une partie du caisson 14 est réalisée une métallisation Schottky 17, tandis que sur l'autre partie du caisson 14 est réalisé un contact ohmique 22 : on ne peut plus dans ce cas réaliser un second contact Schottky tel que le contact 18 de la figure 4 car il y aurait alors deux diodes Schottky sur le caisson 14 et c'est pourquoi la métallisation 22 prend un contact ohmique.

La métallisation Schottky 17 déborde du caisson 14 et est en contact avec une ligne microbande 20, en tous points analogue à la ligne microbande 20 décrite à l'occasion de la figure 4. La métallisation ohmique 22 déborde également du caisson 14 et est en contact électrique avec une seconde ligne microbande 21 et avec le caisson implanté 15. Il y a donc une liaison électrique directe entre la métallisation 16 sur laquelle est appliquée la tension de commande $V_{comm}$, le caisson 14 et la ligne microbande 21. Par contre il y a formation d'une diode Schottky entre la métallisation Schottky 17 et le caisson 14. Les deux métallisations 17 et 22 présentent au moins deux côtés linéaires et parallèles entre eux, distants d'une longueur 19, de l'ordre de 5 μm, qui participe à la formation d'une capacité. La différence entre la figure 7 et la figure 4 est en partie que la ligne microbande 20 est, dans le cas de la figure 7, sous tension continue nulle puisqu'elle est isolée de la tension de commande $V_{comm}$ par la diode Schottky. Par contre la ligne microbande 21, réunie par un contact ohmique 22 à la résistance 11 et au contact 16 sur lequel est appliquée la tension de commande $V_{comm}$, est de ce fait soumise à une tension continue variable, qui est celle qui existe sur la métallisation ohmique 16.

La figure 8 représente une vue en coupe partielle d'un cristal semiconducteur, sur lequel sont déposées deux métallisations, afin de montrer la formation des capacités.

Sur le caisson 14, qui a été implanté dans le substrat de la pastille de circuit intégré, sont déposées deux métallisations Schottky 17 et 18. Lorsque ces métallisations sont soumises à une tension de commande $V_{comm}$, qui vient par l'intermédiaire de la résistance 11 qui est électriquement reliée au caisson 14, deux zones de déplétion 23 et 24 se forment sous les métallisations Schottky 17 et 18, respectivement. Entre les zones de déplétion 23 et 24 et le reste du caisson 14 se forment deux capacités de jonction 25 et 26 respectivement. Ce sont ces capacités, dont la valeur varie avec la tension de commande, c'est-à-dire varie également avec la profondeur des zones de déplétion 23 et 24, qui constituent les capacités variables dans l'élément à capacité variable commandé par une tension de l'invention. En outre, entre les bords des métallisations 17 et 18, qui sont distants d'environ 5 μm, se forme également une capacité 27, qui est fixe puisque la distance entre les métallisations 17 et 18 ne varie pas en fonction de la tension de commande. On retrouve donc sur la figure 8 le schéma en forme de T exposé en figure 2, selon lequel deux capacités varient sous l'effet de la tension appliquée sur une résistance.

La figure 8 permet d'introduire la figure 9 qui représente les dispositions des métallisations, afin d'augmenter la valeur des capacités, ce qui constitue une seconde variante à l'invention.

Puisque les capacités formées par les métallisations Schottky sur la couche active 14 comportent, en partie, une capacité 27 formée entre les bords des métallisations Schottky 17 et 18, il est possible d'augmenter la valeur des capacités 25, 26 en donnant aux deux métallisations 17 et 18 des formes interdigitées : la longueur de l'espace 19 qui sépare les métallisations est plus longue si les métallisations sont interdigitées, ce qui augmente les capacités 25, 26 et 27.

La figure 10 représente le schéma électrique d'un transformateur accordé par une capacité variable selon l'invention. Dans certains circuits, on a besoin de faire intervenir un transformateur comportant un enroulement primaire 28, un enroulement secondaire 29, ces deux enroulements étant réunis en un point commun à la masse 30 par exemple. Mais il est alors nécessaire d'interposer entre les deux extrémités 2 et 3 du transformateur une capacité variable 9 pour accorder le transformateur à double fil en fonction de la fréquence, les extrémités 2 et 3 des deux enroulements correspondant aux extrémités 2 et 3 des figures précédentes, de la figure 5 notamment, c'est-à-dire que au moins le point repéré 2 est soumis à une tension $V_{HF}$.

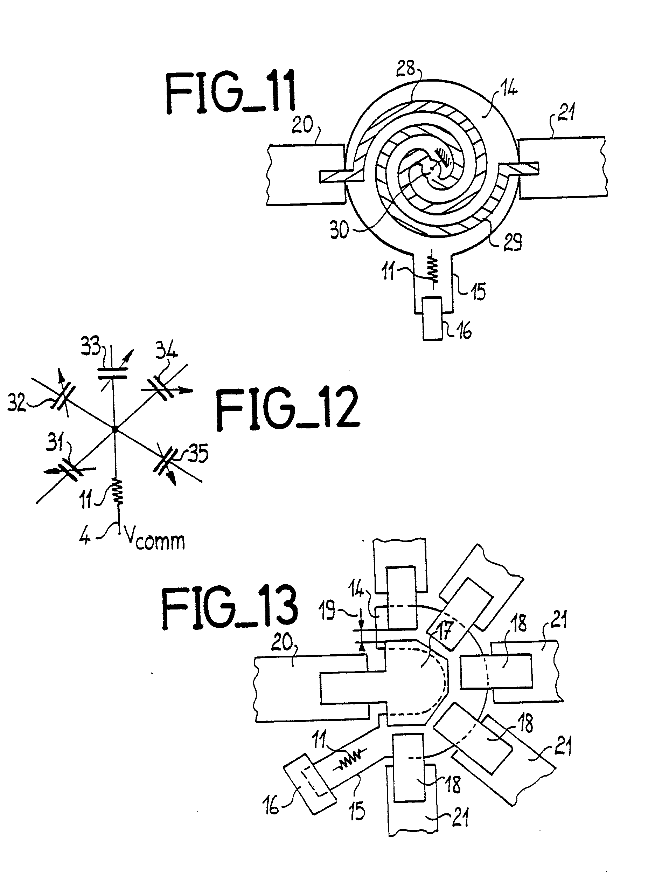

La réalisation d'un tel transformateur est donnée en figure 11. Dans un substrat isolant ou semi-isolant, non représenté sur la figure 11, sont réalisés une zone active 14 et un appendice 15, lequel correspond à la résistance de commande 11. Les régions 14 et 15 sont dopées de type n ou de type p comme cela a été précisé précédemment. Puis, par des opérations de métallisations connues, on dépose sur la zone active 14 un enroulement en double spirale, comportant un premier enroulement 28 qui est relié à une ligne microbande 20 et un second enroulement 29 relié à une autre ligne microbande 21. Le point central de cette double spirale est réuni à la masse 30, soit par l'intermédiaire d'un puits métallisé à travers le substrat de la pastille, soit par un fil. Les lignes d'enroulement 28 et 29 sont des contacts Schottky. La métallisation 16 par laquelle est amenée la tension de commande $V_{comm}$ est un contact ohmique.

La figure 12 représente le schéma équivalent d'un élément à capacité variable comportant une pluralité de capacités variables, qui constituent une troisième variante à l'invention. Alors que dans les figures précédentes, telle que la figure 2, l'élément à capacité variable de l'invention avait une structure en forme de T comportant au maximum deux capacités variables 9 et 10, avec une première variante, illustrée en figure 5, ne comportant qu'une seule capacité variable 9, le schéma de l'élément selon l'invention permet de commander simultanément autant de capacités variables que la technologie permet d'en implanter sur une pastille de circuit intégré. Ainsi sur la figure 12, cinq capacités variables sont représentées, et elles sont commandées simultanément par une unique et même tension de commande $V_{comm}$, mais ce nombre de cinq capacités variables ne constitue pas une limite à la portée de l'invention.

La figure 13 représente un exemple de réalisation de l'élément comportant une pluralité de capacités variables dont le schéma équivalent est donné en figure 12. De même que dans les cas précédents, l'élément comportant une pluralité de capacités variables 31 à 35 comporte, réalisé dans un substrat isolant ou semi-isolant qui n'est pas représenté sur la figure 13, une zone active 14 de type de dopage n ou p. Cette zone active 14 comprend un appendice 15 qui constitue la résistance 11 à travers laquelle est appliquée la tension de polarisation $V_{comm}$ qui provient de la métallisation ohmique 16. Une métallisation Schottky 17 est en partie supportée par la région active 14 et en partie en contact électrique avec une première microbande 20. Des métallisations Schottky, ou éventuellement une métallisation ohmique, indifféremment repérées 18, recouvrent partiellement la région active 14 et sont en contact avec des lignes microbandes 21. Dans ce type de variante à l'invention, avec une pluralité de capacités variables, il ne peut y avoir au maximum qu'une seule métallisation telle que 18 qui soit à contact ohmique, les autres étant à contact Schottky. En effet, s'il n'est pas utile que deux métallisations 18 forment deux diodes avec la couche active 14, il suffit alors de les réunir en une seule métallisation.

La configuration représentée en figure 13 n'est pas exhaustive, et d'autres formes pour la région active 14 entrent dans le domaine de l'invention, pourvu que des métallisations Schottky forment avec une région active une pluralité de diodes ayant toutes leur cathode réunies en un point auquel est appliquée une tension de commande en inverse.

Les applications de l'élément à capacité variable de l'invention se trouvent surtout dans les circuits intégrés hyperfréquences sur Ga As ou matériaux rapides. Cet élément entre dans la réalisation de : oscillateurs accordables, filtres variables, déphaseurs, amplificateurs ou commutateurs. Ces circuits intégrés sont eux-mêmes utilisés dans les radars, systèmes de contremesures, télécommunications, et, de façon plus générale, dans les systèmes hyperfréquences.

**Revendications**

1. Elément à capacité variable, commandable par une tension continue ($V_{comm}$) n'interférant pas avec une tension hyperfréquence ($V_{HF}$) modulée par ledit élément, dont la capacité variable est formée par la jonction d'au moins une diode (12) polarisée en inverse par la tension de commande ($V_{comm}$) à travers une résistance (11), cet élément, dont les bornes d'accès sont constituées par des lignes microbandes (20, 21), comportant :

- une zone active (14), dopée au niveau $10^{17}$ at.cm$^{-3}$, implantée dans un substrat semiconducteur en matériau semi-isolant ($n_D \leqslant 10^{14}$ at.cm$^{-3}$) et

- au moins deux métallisations séparées (17, 18), chacune recouvrant partiellement la zone active (14) et partiellement une microbande d'accès (20, 21), l'une au moins (17) desdites métallisations formant avec la zone active (14) une diode Schottky, ladite résistance (11) étant formée par un appendice (15) de la zone active (14), également implanté dans le substrat semiconducteur latéral à la zone active (14), en contact ohmique avec ladite zone active (14), et partiellement recouvert par une métallisation ohmique (16) sur laquelle est appliquée la tension de commande ($V_{comm}$), les dimensions et le taux de dopage de cet appendice (15) permettant de déterminer la valeur de la résistance (11).

2. Elément à capacité variable selon la revendication 1, caractérisé en ce que les deux métallisations (17, 18) sont des métallisations Schottky, et en ce que l'élément comporte deux diodes Schottky (12, 13) formées par la jonction entre métallisations et couche active (14), les deux diodes (12, 13) étant montées en cathode commune.

3. Elément à capacité variable selon la revendication 1, caractérisé en ce qu'une première métallisation (17) est à contact Schottky, et une seconde métallisation (22) est à contact ohmique, et en ce que l'élément comporte une seule diode Schottky (12), dont la cathode reçoit la tension de commande ($V_{comm}$) et dont l'anode est en liaison directe avec le signal hyperfréquence ($V_{HF}$).

4. Elément à capacité variable selon la revendication 1, caractérisé en ce que la zone active (14) et son appendice (15) sont dopés de type n.

5. Elément à capacité variable selon la revendication 1, caractérisé en ce que, en vue d'augmenter la densité d'intégration par augmentation de la résistance de la zone dopée, la zone active (14) et son appendice (15) sont dopés de type p.

6. Elément à capacité variable selon la revendication 1, caractérisé en ce que, en vue d'augmenter la capacité formée entre les bords en regard des métallisations (17, 18) sur la zone active (14), ceux-ci ont une forme interdigitée, et sont séparés par un espace constant (19).

7. Elément à capacité variable selon la revendication 1, caractérisé en ce que deux métallisations Schottky (28, 29), ayant un point commun à la masse (30) et déposées en une double spirale sur la zone active (14), elle-même réunie à travers ladite résistance (11) à la tension de commande ($V_{comm}$), forment un transformateur avec circuit accordé.

8. Elément à capacité variable selon la revendication 2, caractérisé en ce que les deux lignes microbandes (20, 21) sont à une tension continue nulle (OV).

9. Elément à capacité variable selon la revendication 3, caractérisé en ce que la ligne microbande (20) en contact avec la métallisation Schottky (17) est à une tension continue nulle (OV) et en ce que la ligne microbande (21) en contact avec la métallisation ohmique (22) est à la tension continue de commande ($V_{comm}$).

10. Elément à capacité variable selon l'une quelconque des revendications précédentes, caractérisé en ce qu'il est intégré dans une pastille de matériau de la famille III-V, dont le substrat est binaire (Ga As, In P...) et la couche active est binaire ou ternaire (Al Ga As, Ga In P...).

**Claims**

1. A variable capacity element, which may be controlled by a dc-voltage ($V_{comm}$) not interfering with a microwave voltage ($V_{HF}$) modulated by said element, the variable capacity being constituted by the junction of at least one diode (12), which is inversely biassed by a control voltage ($V_{comm}$) via a resistance (11), said element, whose access terminals are constituted by microstrip-lines (20, 21), comprises :

- an active zone (14), doped at the level $10^{17}$ at.cm$^{-3}$, implanted in a semiconducting substrate made of semi-insulating material ($n_D \leqslant 10^{14}$ at.cm$^{-3}$), and

- at least two separate metallizations (17, 18) each partially covering the active zone (14) and partially an access microstrip (20, 21) and at least one (17) of said metallizations constituting

together with the active zone (14) a Schottky diode, wherein said resistance (11) is formed by an appendix (15) of the active zone (14), which appendix is also implanted in the semiconducting substrate, laterally to the active zone (14), in ohmic contact with said active zone (14) and partially covered by an ohmic metallization (16), to which the control voltage ($V_{comm}$) is applied, the dimensions and the doping rate of this appendix (15) permitting to determine the value of the resistance (11).

2. A variable capacity element according to claim 1, characterized in that the two metallizations (17, 18) are Schottky metallizations, and that the element comprises two Schottky diodes (12, 13) formed by the junction between the metallizations and the active layer (14), the two diodes (12, 13) being mounted in common cathode connection.

3. A variable capacity element according to claim 1, characterized in that a first metallization (17) is of the Schottky contact type and a second metallization (22) is of the ohmic contact type, and that the element comprises a sole Schottky diode (12), whose cathode receives the control voltage ($V_{comm}$) and whose anode is in direct connection with the microwave signal ($V_{HF}$).

4. A variable capacity element according to claim 1, characterized in that the active zone (14) and its appendix (15) are provided with n-type doping.

5. A variable capacity element according to claim 1, characterized in that, in order to increase the density of integration by way of increasing the resistance of the doped zone, the active zone (14) and its appendix (15) are provided with p-type doping.

6. A variable capacity element according to claim 1, characterized in that, in order to increase the capacity formed between the opposing edges of the metallizations (17, 18) on the active zone (14), the latter are given an interdigiting shape and are separated from one another by a constant space (19).

7. A variable capacity element according to claim 1, characterized in that the two Schottky metallizations (28, 29), which have a common mass point (30) and are deposited according to a double spiral on the active zone (14), the latter in turn being connected to the control voltage ($V_{comm}$) via said resistance (11), constitute a transformer associated with a tuned circuit.

8. A variable capacity element according to claim 2, characterized in that the two microstrip lines (20, 21) are biassed to dc-voltage null (OV).

9. A variable capacity element according to claim 3, characterized in that the microstrip line (20) in contact with the Schottky metallization (17) is biassed to dc-voltage null (OV) and that the microstrip line (21) in contact with the ohmic metallization is biassed to the dc-control voltage ($V_{comm}$).

10. A variable capacity element according to any one of the preceding claims, characterized in that it is integrated into a dice of material belonging to the group III-V, whose substrate is binary (Ga As, In P...) and the active layer is binary or ternary (Al Ga As, Ga In P...).

**Patentansprüche**

1. Element mit variabler Kapazität, das durch eine Gleichspannung ($V_{comm}$) steuerbar ist, die nicht mit einer Mikrowellenspannung ($V_{HF}$) interferiert, welche durch das Element moduliert wird, und dessen variable Kapazität durch den Zonenübergang mindestens einer Diode (12) gebildet wird, die von der Steuerspannung ($V_{comm}$) über einen Widerstand (11) in umgekehrter Richtung vorgespannt wird und wobei das Element, dessen Anschlußklemmen durch Mikrostripleitungen (20, 21) gebildet werden, aufweist :
- eine aktive Zone (14), welche auf dem Niveau $10^{17}$ at.cm$^{-3}$ dotiert und in ein Halbleitersubstrat aus halb-isolierendem Material ($n_D \leqslant 10^{14}$ at.cm$^{-3}$) implantiert ist, und
- mindestens zwei getrennte Metallisierungen (17, 18), die je teils die aktive Zone (14) und teils einen Anschlußmikrostrip (20, 21) teilweise überdecken, wobei mindestens eine (17) der Metallisierungen mit der aktiven Zone (14) eine Schottkydiode bildet, wobei der Widerstand (11) durch einen gleichfalls in das Halbleitersubstrat implantierten Fortsatz (15) der aktiven Zone gebildet wird, der sich seitlich der aktiven Zone (14) und im ohm'schen Kontakt mit dieser befindet und teilweise von einer ohm'schen Metallisierung (16) bedeckt ist, an die die Steuerspannung ($V_{comm}$) angelegt wird, wobei die Abmessungen und der Dotierungsgrad des Fortsatzes (15) die Größe des Widerstands (11) bestimmen.

2. Element mit variabler Kapazität nach Anspruch 1, dadurch gekennzeichnet, daß die beiden Metallisierungen (17, 18) Schottky-Metallisierungen sind und daß das Element zwei Schottkydioden (12, 13) umfaßt, welche durch den Zonenübergang zwischen den Metallisierungen und der aktiven Zone (14) gebildet werden, wobei die beiden Dioden (12, 13) kathodenseitig miteinander verbunden sind.

3. Element mit variabler Kapazität nach Anspruch 1, dadurch gekennzeichnet, daß eine erste Metallisierung (17) eine Schottky-Kontaktverbindung und eine zweite Metallisierung (22) eine ohm'sche Kontaktverbindung ist, und daß das Element eine einzige Schottkydiode (12) besitzt, deren Kathode an der Steuerspannung ($V_{comm}$) liegt und deren Anode in direkter Verbindung mit dem Mikrowellensignal ($V_{HF}$) steht.

4. Element mit variabler Kapazität nach Anspruch 1, dadurch gekennzeichnet, daß die aktive Zone (14) und ihr Fortsatz (15) n-dotiert sind.

5. Element mit variabler Kapazität nach Anspruch 1, dadurch gekennzeichnet, daß zur Vergrößerung der Integrationsdichte durch Erhöhung des Widerstandes der dotierten Zone die aktive Zone (14) und ihr Fortsatz (15) p-dotiert sind.

6. Element mit variabler Kapazität nach Anspruch 1, dadurch gekennzeichnet, daß zur Vergrößerung der zwischen den einander gegenüberliegenden Rändern der Metallisierungen (17, 18) auf der aktiven Zone (14) gebildeten Kapazität dieselbe eine verzahnte Form aufweisen und durch einen konstanten Zwischenraum (19) voneinander getrennt sind.

7. Element mit variabler Kapazität nach Anspruch 1, dadurch gekennzeichnet, daß die beiden Schottky-Metallisierungen (28, 29) einen Transformator mit Abstimmkreis bilden, wobei sie einen gemeinsamen Massepunkt (30) besitzen und in doppelter Spirale auf die aktiven Zone (14) aufgebracht sind, die ihrerseits über den Widerstand (11) an die Steuerspannung ($V_{comm}$) gelegt ist.

8. Element mit variabler Kapazität nach Anspruch 2, dadurch gekennzeichnet, daß die beiden Mikrostripleitungen (20, 21) an Gleichspannung Null (OV) liegen.

9. Element mit variabler Kapazität nach Anspruch 3, dadurch gekennzeichnet, daß die in Kontakt mit der Schottky-Metallisierung (17) stehende Mikrostripleitung (20) an Gleichspannung Null (OV) und die mit der ohm'schen Metallisierung in Kontakt stehende Mikrostripleitung (21) an der Steuergleichspannung ($V_{comm}$) liegt.

10. Element mit variabler Kapazität nach einem beliebigen der vorhergehenden Ansprüche, dadurch gekennzeichnet, daß es in einen Chip aus einem Material der Gruppe III-V integriert ist, deren Substrat binärer Natur (Ga As, In P...) und deren aktive Schicht binärer oder ternärer Natur (Al Ga As, Ga In P...) ist.

FIG_1

PRIOR ART

$V_{HF}$

$V_{comm}$

$L_1$ $L_2$

$C_1$ $C_2$

FIG_2

$V_{HF}$

$V_{comm}$

FIG_3

$V_{HF}$

$V_{comm}$

FIG_4

FIG_7

# FIG_5

$V_{HF}$  9  3

2  11

4  $V_{comm}$

# FIG_6

$V_{HF}$  12  3

2  11

4  $V_{comm}$

# FIG_8

17  27  18

23  25  26  24

11

$V_{comm}$

14

# FIG_9

17  14  19  18  21

20

11  15

16

# FIG_10

9

2  3

28  29

30

FIG_11

FIG_12

FIG_13